# EUROPÄISCHE PATENTSCHRIFT

(11) **EP 3 041 847 B1**
(45) Veröffentlichungstag und Bekanntmachung des Hinweises auf die Patenterteilung: **27.09.2017**
(21) Anmeldenummer: 14747526.3
(22) Anmeldetag: 04.08.2014
(51) Int. Cl.: C07F 3/00, C07F 5/00, C07F 7/00, C07F 7/22, C12P 3/00, C23C 16/00, C23C 16/44

(54) **VORPRODUKTE FÜR DIE HERSTELLUNG VON DÜNNEN OXIDISCHEN SCHICHTEN UND DEREN ANWENDUNG**
PRECURSORS FOR THE PRODUCTION OF THIN OXIDE LAYERS AND THE USE THEREOF
PRÉCURSEURS POUR LA PRODUCTION DE COUCHES OXYDIQUES ET UTILISATION DESDITS PRÉCURSEURS

(30) Priorität: 03.09.2013 EP 13004323
(43) Veröffentlichungstag der Anmeldung: 13.07.2016
(73) Patentinhaber: Merck Patent GmbH, 64293 Darmstadt (DE)
(72) Erfinder: BONRAD, Klaus, 64665 Alsbach-Haehnlein (DE); SCHNEIDER, Joerg, 64342 Seeheim-Jugenheim (DE); HOFFMANN, Rudolf, 64291 Darmstadt (DE); KALOUMENOS, Mareiki, 81673 München (DE)
(86) Internationale Anmeldenummer: PCT/EP2014/002140
(87) Internationale Veröffentlichungsnummer: WO 2015/032462

(56) Entgegenhaltungen:
- GB-A- 1 040 383
- ROBERT M. PASQUARELLI ET AL: "Solution processing of transparent conductors: from flask to film", CHEMICAL SOCIETY REVIEWS, Bd. 40, Nr. 11, 1. Januar 2011 (2011-01-01), Seite 5406, XP55145934, ISSN: 0306-0012, DOI: 10.1039/c1cs15065k

## Beschreibung

Die vorliegende Erfindung betrifft neue Vorprodukte in Form von Metallkomplexen mit in 2-Position substituierten 1,3-Diketonen und ein Verfahren zu deren Herstellung. Gegenstand der Erfindung ist weiterhin deren Verwendung zur Herstellung von dünnen Metalloxidschichten. Letztere stellen Bestandteile in verschiedensten elektronischen Bauteilen und Vorrichtungen mit unterschiedlichen Funktionen dar.

### Stand der Technik

Die Herstellung von funktionalen keramischen Schichten durch Aufbringen von Lösungen oder Dispersionen bietet als Formgebungsverfahren viele verfahrenstechnische Vorteile. In Abhängigkeit vom zu beschichtenden Substrat und der abzuscheidenden oxidischen Schichten wurden verschiedenste Verfahren und eine Vielzahl von Techniken entwickelt, die sowohl die Herstellung von flächigen als auch strukturierten Beschichtungen erlauben. Der Auftrag chemischer Zusammensetzungen, die als Ausgangsmaterialien zur Bildung der Schichten dienen, kann beispielsweise durch Spincoating, Spraycoating oder Inkjet-Printing erfolgen. Gegenüber Hochvakuumtechniken sind diese Applikationsverfahren im Allgemeinen apparativ weniger aufwendig und vorteilhafterweise für kontinuierlich arbeitende Herstellungslinien besser geeignet, wodurch eher eine Durchführung im technischen Maßstab ermöglicht wird.

Für die Herstellung geeigneter Beschichtungslösungen oder -dispersionen bieten sich grundsätzlich zwei verschiedene Routen an.
Einerseits können geeignete Partikel zur Ausbildung der aufzubringenden Oxidschichten unter Zusatz von Additiven, wie z. B. Verflüssiger, Stabilisatoren, Binder oder Entschäumer, in eine Dispersion überführt werden. Nach der Applikation und Trocknung der Dispersion auf dem Substrat ist ein Ausbrennen der organischen Zusätze erforderlich. Alternativ können Lösungen von geeigneten chemischen Verbindungen, welche als Vorprodukte, im Folgenden auch als Precursor bezeichnet, für die herzustellende oxidische Beschichtung dienen, eingesetzt werden. Solche Lösungen weisen typischerweise eine größere Lagerfähigkeit und Beständigkeit auf als Dispersionen von Partikeln. Nach dem Aufbringen auf dem Substrat ist hier eine Konversion durch Temperaturbehandlung in das gewünschte Oxid erforderlich.
Gemeinsam ist beiden Verfahren, dass sich die erforderlichen Temperaturen zur Durchführung über einen Bereich von mehreren hundert Grad erstrecken.
Für die Herstellung komplexer Bauteile ist jedoch die Behandlung bei sehr hohen Temperaturen meist unerwünscht, da dieses die Auswahl an zu beschichtenden Substraten einschränkt und störende Reaktionen an Grenzflächen sowie Interdiffusion auftreten können. Zur Reduzierung der Prozesstemperatur sind in der Vergangenheit unterschiedliche Wege eingeschlagen worden. Neben der Optimierung der Prozessparameter bietet sich im Fall der Verwendung von Vorprodukten eine chemische Modifikation am molekularen Grundgerüst der Liganden im Metallkomplex an.

Die Herstellung von funktionalen oxidischen Schichten aus Vorprodukten durch Aufbringen aus einer Lösung und anschließender thermischer Prozessierung ist jedoch in ihrer Anwendungsbreite immer noch beschränkt. Für die Abscheidung aus einer Lösung sind gute Löslichkeit der Vorprodukte in für die Beschichtung geeigneten Lösemitteln, Stabilität der Lösung unter Umgebungs- und Beschichtungsbedingungen, Benetzung des Substrats durch die Lösung und eine möglichst geringe Konversionstemperatur in einem engen Temperaturbereich erforderlich. Daher ist die Verwendung von Vorprodukten, die üblicherweise in Vakuumprozessen, wie z. B. im CVD-Verfahren (Chemical Vapour Deposition), eingesetzt werden, im Regelfall nicht möglich, da für dieses Verfahren thermisch stabile und gut sublimierbare Verbindungen verwendet werden. Für die Abscheidung aus Lösung hingegen ist auch geringfügige Sublimation während der Konversion in die oxidische Schicht, vor allem bei multinären oder mehrphasigen Systemen, unerwünscht, da die Ausbildung einer definierten Zusammensetzung erschwert wird.

Bei einer bisher verwendeten Gruppe von Vorprodukten handelt es sich um ein Ligandensystem in Form von Kondensationsprodukten sogenannter Schiffscher Basen ("Oximate"), insbesondere Methoxyiminopropionsäure. Die Verwendung dieser Verbindungen bietet viele Vorteile hinsichtlich der Prozessierung, der Filmbildung und Nachbehandlung im abgeschiedenen Film. So kann etwa nach der thermischen Konversion eine halbleitende Schicht hergestellt werden, die Verwendung in Dünnschichttransistoren finden kann. Nachteile in der Verwendung dieser Verbindungsklasse sind neben den immer noch hohen Zersetzungstemperaturen, Schwierigkeiten letztere ohne Spurenverunreinigungen durch Alkalimetall- oder Halogenidionen herzustellen. Des Weiteren sind die Ausgangsprodukte für die Kondensationsreaktion der Schiffschen Base, d. h. alpha-Ketosäuren und O-Alkoxylamine, nur begrenzt ohne größeren Aufwand modifizierbar, da eine hohe Anzahl von Syntheseschritten erforderlich ist, die jedoch zu geringen Ausbeuten führen.

### Zu lösende Aufgabe

Aufgabe der vorliegenden Erfindung ist es daher, ein einfach und sicher durchführbares Verfahren zur Herstellung geeigneter Vorprodukte zur Verfügung zu stellen, das die beschriebenen Nachteile vermeidet und mittels eines leicht zu derivatisierenden Ligandensystems durchführbar ist, wobei die so hergestellten Vorprodukte in einfacher Weise bei möglichst niedrigen Temperaturen zum korrespondierenden Metalloxid umgewandelt werden können ohne Bildung größerer Anteile organischer Rückstände, die durch Temperaturbehandlung ausgetrieben werden müssen. Aufgabe der vorliegenden Erfindung ist es somit auch, Liganden zur Verfügung zu stellen, die leicht in flüchtige Bestandteile zerfallen.

### Gegenstand der Erfindung

Es wurde nun gefunden, dass die erfindungsgemäße Aufgabe gelöst werden kann durch neue Metallkomplexe mit in 2-Position substituierten 1,3-Diketonen der allgemeinen Formel (I)

Mₗ[R¹-CO-C(H)ₘX-CO-R²]ₙ, (I)

worin
- M: Metallatom, ausgewählt aus der Gruppe Zink, Indium, Gallium, Zinn, Aluminium, Zirkonium, Titan und Hafnium,
- I: 1 oder 2, bei Clusterbildung ≥ 2,
- m: 0 oder 1,
- n: 1, 2, 3 oder 4, bei Clusterbildung > 2,
- R¹, R²,: unabhängig voneinander Alkyl mit 1 bis 8 C-Atomen, Cycloalkyl mit 3 bis 7 C-Atomen, Alkoxy mit 1 bis 8 C-Atomen oder Amino, NHR³, NR³R⁴ mit R³, R⁴ unabhängig voneinander Alkyl mit 1 bis 8 C-Atomen, Cycloalkyl mit 3 bis 7 C-Atomen, und
- X: H, Hydroxyimino-, Nitro, Sulfo, einschließlich -SO₂-alkyl mit 1 bis 8 C-Atomen, Phosphato, einschließlich -PO(O-R)₂ mit R = alkyl mit 1 bis 8 C-Atomen, Alkoxy mit 1 bis 8 C-Atomen; Stannyl -SnR₃ mit R = alkyl mit 1 bis 8 C-Atomen; Mercapto-SR mit R = H, alkyl mit 1 bis 8 C-Atomen, cycloalkyl mit 3 bis 7 C-Atomen, Halogenid, wie F, Cl, Br, I oder Pseudohalogenid, wie -CN, -N₃, -OCN, -NCO, -CNO, -SCN, -SeCN
bedeuten, mit der Maßgabe dass es sich bei dem Metallkomplex nicht um Tetrakis-(cyanodiethylmalonat)-zirkonium handelt. Insbesondere durch solche 1,3-Diketone, worin R¹, R², R³ und R⁴ unabhängig voneinander Methyl, Ethyl, Propyl, Butyl, Pentyl, Cyclopropyl, Cyclobutyl, Cyclopentyl, Cyclohexyl, Methoxy, Ethoxy, Propoxy und im Fall von R¹ und R² Amino bedeuten. Vorzugsweise nimmt X bzw. HX in diesen 1,3-Diketonen die Bedeutung Hydroxyimino-, Nitro, Sulfo, einschließlich -SO₂-alkyl mit 1 bis 8 C-Atomen, Halogenid, wie F, Cl, Br, I oder Pseudohalogenid, wie -CN, -N₃, -OCN, -NCO, -CNO, -SCN, - SeCN an. Aus dieser Gruppe von 1,3-Diketonen sind Verbindungen ausgewählt aus der Gruppe Nitrodimethylmalonat, Hydroxyiminodimethylmalonat und Nitromalonsäurediamid besonders zur Lösung der erfindungsgemäßen Aufgabe geeignet. Diese 1,3-Diketone bilden als Liganden mit einem Metallatom M, ausgewählt aus der Gruppe Zink, Indium, Gallium, Zinn, Aluminium, Zirkonium, Titan und Hafnium, Metallkomplexe der allgemeinen Formel (I) aus, die bereits bei niedrigen Temperaturen zu den entsprechenden Metalloxiden umgewandelt werden können. Gegebenenfalls können auch entsprechende Komplexe anderer hier nicht aufgezählter Metalle in gleicher Weise hergestellt werden. Aufgrund der Eigenschaften der hier vorgestellten Liganden weisen diese Metallkomplexe in gleicher Weise niedrige Zersetzungstemperaturen auf und sind in gleicher Weise einsetzbar wie die hier beschriebenen Komplexe. Durch Versuche wurde gefunden, dass Metallkomplexe der 1,3-Diketon(en) der allgemeinen Formel (I) ausgewählt aus der Gruppe Nitrodimethylmalonat, Hydroxyiminodimethylmalonat und Nitromalonsäurediamid besonders für die gewünschte Umwandlung in die korrespondierenden Metalloxide unter Ausbildung einer dünnen, gegebenenfalls keramischen, Oxidschicht und Zersetzung der Liganden in flüchtige Bestandteile geeignet sind.

Die erfindungsgemäßen Metallkomplexe der allgemeinen Formel (I) können in Form von Clustern vorliegen, die sich durch Assoziation von Metallkomplexmolekülen und gegebenenfalls unter Freisetzung von einzelnen Liganden bilden. Dementsprechend nimmt in solchen Clustern die Zahl I einen Wert größer gleich 2 an. Die Zahl n erhöht sich entsprechend und ist größer als 2.

Zur Durchführung des Verfahrens zur Herstellung von dünnen Metalloxidschichten wird (werden) ein oder mehrere Metallkomplex(e), wie oben beschrieben, in einem geeigneten Lösungsmittel oder Lösungsmittelgemisch, gegebenenfalls in Gegenwart von Wasser, gelöst oder dispergiert,
die erhaltene Lösung oder Dispersion, der gegebenenfalls weitere Additive, ausgewählt aus der Gruppe Verflüssiger, Stabilisatoren, Binder und Entschäumer und gegebenenfalls weitere, zugesetzt sind, mittels Nassbeschichtung auf eine zu beschichtende Substratoberfläche aufgebracht, getrocknet,
und in einem weiteren Schritt wird die aufgebrachte Metallkomplexschicht mittels Erhitzen in einem Ofen, auf einer Heizplatte, oder mittels Bestrahlen durch UV, IR oder Laser in ein Metalloxid in Form einer dünnen Schicht umgewandelt.
Zur Herstellung der Lösung oder Dispersion sind insbesondere Lösungsmittel ausgewählt aus der Gruppe Methoxyethanol, Dimethylformamid und Dimethoxyethan geeignet, die rein oder im Gemisch, gegebenenfalls auch in Gegenwart von Wasser, eingesetzt werden können.

Das Aufbringen der das Metallkomplex enthaltenden Lösung oder Dispersion kann in diesem Verfahren mittels Spincoating, Dipcoating, Spraycoating, Gravurdruck, Inkjet-Druck oder Flexodruck auf die Substratoberfläche erfolgen. Besonders vorteilhaft gestaltet sich das Verfahren, wenn die das entsprechende Metallkomplex enthaltende Lösung oder Dispersion Lösungsmittel ausgewählt aus der Gruppe Methoxyethanol, Dimethylformamid und Dimethoxyethan einzeln oder im Gemisch und gegebenenfalls Wasser enthält. Die Umwandlung der so aufgebrachten und getrockneten Metallkomplexschicht in eine dünne Oxidschicht kann überraschend durch Erhitzen und Kalzinieren bei niedrigeren Temperaturen als in vergleichbaren bekannten Verfahren erfolgen, vorzugsweise bei Temperaturen im Bereich von 150 - 350 °C. Auf diese Weise können erfindungsgemäß in einem einfach durchführbaren Verfahren dünne keramische Oxidschichten der Metalle Zink, Indium, Gallium, Zinn, Aluminium, Zirkonium, Titan und Hafnium oder anderer geeigneter Metalle hergestellt werden. Insbesondere können auf diese Weise Schichten hergestellt werden, worin die Oxide rein oder im Gemisch, bzw. als Mischoxide vorliegen.

Falls dieses zur Ausbildung von ausreichend dicken bzw. von dichten homogenen Schichten erforderlich ist, wird vor dem Erhitzen und Kalzinieren mehrfach die Lösung oder Dispersion auf die Substratoberfläche aufgebracht, wobei jede Schicht einzeln getrocknet und getempert wird.

Das hiermit zur Verfügung gestellte Verfahren ist sehr universell einsetzbar, und die neuen Metallkomplexe, welche Liganden in Form der 1,3-Diketone gemäß der allgemeinen Formel (I) enthalten, können zur Herstellung von dünnen Metalloxidschichten in elektronischen Bauteilen, wie Kondensatoren oder Dünnschichttransistoren, in der Photovoltaik, der Halbleitertechnologie oder als Antikratz- oder Antireflexschichten verwendet werden. Das Verfahren ist aber auch geeignet, um dünne Metalloxidschichten in Solarzellen, Flachbildschirmen und Touchscreens, als Halbleiter in Feldeffekttransistoren unter Verwendung dieser erfindungsgemäßen Metallkomplexe herzustellen.

### Ausführliche Beschreibung der Erfindung

Durch Versuche wurde überraschender Weise gefunden, dass eine neue Materialklasse von Metallkomplexen mit in 2-Position funktionalisierten 1,3-Diketonen der allgemeinen Formel (I)

Mₗ[R¹-CO-C(H)ₘX-CO-R²]ₙ, (I)

mit
- M: Metallatom, ausgewählt aus der Gruppe Zink, Indium, Gallium, Zinn, Aluminium, Zirkonium, Titan und Hafnium,
- l: 1 oder 2, bei Clusterbildung ≥ 2,
- m: 0 oder 1,
- n: 1, 2, 3 oder 4, bei Clusterbildung > 2,
- R¹ und R²: unabhängig voneinander Alkyl mit 1 bis 8 C-Atomen, Cycloalkyl mit 3 bis 7 C-Atomen, Alkoxy mit 1 bis 8 C-Atomen und/oder Amino, NHR³, NR³R⁴ mit R³, R⁴ unabhängig voneinander Alkyl mit 1 bis 8 C-Atomen, Cycloalkyl mit 3 bis 7 C-Atomen, und
- X: H, Hydroxyimino-, Nitro, Sulfo, einschließlich -SO₂-alkyl mit 1 bis 8 C-Atomen, Phosphato, einschließlich -PO(O-R)₂ mit R = Alkyl 1 bis 8 C-Atomen, Alkoxy mit 1 bis 8 C-Atomen; Stannyl -SnR₃ mit R = Alkyl mit 1 bis 8 C-Atomen; Mercapto -SR mit R = H, Alkyl mit 1 bis 8 C-Atomen, Cycloalkyl mit 3 bis 7 C-Atomen, Halogenid, wie F, Cl, Br, I oder Pseudohalogenid, wie -CN, -N₃, -OCN, -NCO, -CNO, -SCN, -SeCN,
mit der Maßgabe dass es sich bei dem Metallkomplex nicht um Tetrakis-(cyanodiethylmalonat)-zirkonium handelt für die beschriebenen Anforderungen besonders gut geeignet ist. Dieses gilt ebenso für Cluster dieser Metallkomplexe der allgemeinen Formel (I), die sich durch Assoziation und gegebenenfalls Freisetzung von Liganden ergeben, wodurch I und n jeweils unabhängig voneinander einen Wert größer gleich 2 annehmen. In solchen Clustern kann I einen Wert von mehreren Tausend annehmen. Das Gleiche gilt dementsprechend auch für n. Üblicherweise bedeutet I in einem Cluster der Metallkomplexe der allgemeinen Formel (I) eine Zahl ≥ 2 bis 160. Die Zahl für n ändert sich in Abhängigkeit von der Zahl der assoziierten Metallkomplexmoleküle. Für hier angesprochene Zwecke sind solche Cluster geeignet, in denen die Zahl der Metallkerne I im Bereich ≥ 2 bis 40 liegt.

Für die Synthese der Metallkomplexe kann aus einer Vielzahl von Liganden ausgewählt werden, da die Funktionalisierung von 1,3-Diketonen [R¹-CO-CH₂-CO-R² mit R¹, R² =, wie oben aufgezählt Alkyl, Alkoxy und/oder Amino (NH₂, NHR³, NR³R⁴)] in 2-Position durch unterschiedlichste Gruppen X bzw. HX in einfachder Weise möglich ist und zwar sowohl für entsprechende Diketone bei denen die Bindung der Gruppen in 2-Position durch einfache oder durch doppelte Bindung erfolgt. Zur Synthese sind wenige Schritte erforderlich, die gleichzeitig zu guten Ausbeuten führen. Bei den Gruppen X bzw. HX kann es sich, wie oben aufgezählt, um Hydroxyimino- (=NOH), oder Nitro (-NO₂),
Sulfo (-SO₂(R)), Phosphato (-PO(OCH₃)₂), Alkoxy (-OR), Stannyl (-SnR₃), Mercapto (-SH, -SR), Halogenid, wie F, Cl, Br, I oder Pseudohalogenid, wie -CN, -N₃, -OCN, -NCO, -CNO, -SCN, -SeCN, handeln und wobei die Reste R die oben gegebenen Bedeutungen haben können. Diese Liganden lassen sich typischerweise gut durch Destillation, Sublimation oder Umkristallisation aufreinigen.
Aufgrund der Acidität der Liganden können für die nachfolgende Synthese der Metallkomplexe Verbindungen der Metalle selbst eingesetzt werden, die mit dem gewählten Ligandensystem den gewünschten Komplex bilden, wie beispielsweise Alkoxide, Alkyle, Carboxylate oder Carbonate der Metalle. Hierdurch lassen sich Verunreinigungen durch Alkalimetalle oder Halogenide erheblich verringern bzw. völlig vermeiden. Der Einsatz von anderen Metallverbindungen wie Halogeniden, Nitraten oder anderen Salzen ist jedoch grundsätzlich ebenfalls möglich. Als Metallverbindungen für die Herstellung des Komplexsystems sind insbesondere Alkoxide, Alkyle, Carboxylate, Halogenide oder Carbonate der Metalle Zink, Indium, Gallium, Zinn, Aluminium, Zirkonium, Titan und Hafnium geeignet. Einschränkungen bezüglich des im Komplex enthaltenen Metallelements bestehen nur im Hinblick auf ungewöhnliche Oxidationsstufen, die auch im Komplex noch stark oxidierende oder reduzierende Eigenschaften aufweisen. Letztere sind für im Sinne der hier vorliegenden Erfindung ungeeignet.

Erfindungsgemäß kann durch die Wahl der Funktionalisierung durch X oder XH, aber auch durch die Substituenten R¹ und R², der Zerfallsprozess des hergestellten Metallkomplexes zu dem korrespondierenden Metalloxid, und somit auch die Zerfallstemperatur, deutlich beeinflusst werden. Darüber hinaus wird erfindungsgemäß durch eine einfache Modifikation der Substituenten des Liganden des Metallkomplexes gemäß der allgemeinen Formel (I) eine verbesserte Löslichkeit erzielt. Dieses ist vor allem durch Wahl von R¹ und R², insbesondere aber auch durch die Einführung geeigneter Gruppen X bzw. HX möglich. Durch geeignete Wahl der Substituenten kann eine Steigerung der Löslichkeit der Metallkomplexe erzielt werden. Gleichzeitig ist es möglich, durch die gewählten Substituenten die Bandbreite der einsetzbaren Lösungsmittel zu vergrößern.

Durchgeführte Versuche haben gezeigt, dass die hier beschriebenen Metallkomplexe der in 2-Position funktionalisierten 1,3-Diketone der allgemeinen Formel (I)

Mₗ[R¹-CO-C(H)ₘX-CO-R²]ₙ,

sich bei überraschend niedrigeren Temperaturen in eine Oxid-Schicht umwandeln lassen.

Wie sich gezeigt hat, sind die neuen, leicht zugänglichen Vorprodukte generell geeignet für die Abscheidung dünner oxidischer Schichten aus Lösung. Damit ist eine breite Anwendung dieser Verbindungsklasse in sehr unterschiedlichen Bereichen möglich. Neben der Verwendung zur Herstellung von elektronischen Schaltelementen (Dünnschichttransistoren) ist auch ihr Einsatz in Prozessen der Photovoltaik möglich oder zur Herstellung von Antikratz- oder Antireflexschichten.

Die auf diese Weise bei niedrigen Temperaturen hergestellte Oxidschichten erfüllen insbesondere die hohen Anforderungen, welche an funktionale Schichten beispielsweise in der Herstellung von Halbleitern in Feldeffekttransistoren gestellt werden.

Durch die vorliegende Erfindung werden demgemäß
a) eine Syntheseroute für neue Metallkomplexe zur Verfügung gestellt, die sich bei niedrigeren Temperaturen zu den korrespondierenden Metalloxiden in Form von dünnen Schichten umsetzen lassen unter Freisetzung leicht flüchtiger organischer Zersetzungsprodukte und
b) neue Vorprodukte in Form von Metallkomplexen zur Verfügung gestellt, welche in einem einfach und sicher durchführbaren Verfahrensschritt in der Herstellung von Feldeffekttransistoren und anderen elektronischen Bauteilen eingesetzt werden können, wodurch
c) diese neuen Materialien bzw. Metallkomplexe in technischen Gebieten, wie z. B. in optischen Anwendungen zur Herstellung von Antireflexschichten, etc., oder als mechanische Schutzschichten in Form von Antikratzschichten einsetzbar sind.

Die Herstellung der erfindungsgemäßen Liganden und der als Vorprodukte für die Herstellung der dünnen Metalloxidschichten dienenden Metallkomplexe kann nach aus der Literatur und dem Fachmann allgemein bekannten Methoden erfolgen.

Dementsprechend kann die Synthese der in den folgenden Beispielen verwendeten Liganden und Metallkomplexe nach bekannten Literaturverfahren erfolgen. Als Ausgangsmaterial können kommerziell erhältliche 1,3-Diketone [R¹-CO-CH₂-CO-R² mit R¹, R² = Alkyl, Alkoxy und/oder Amino(NH₂, NHR³, NR³R⁴)] eingesetzt werden. Ebenso erfolgt die Funktionalisierung in 2-Position nach literaturbekannten Verfahren.

Die Nitrosierung der 1,3-Diketone mit den Resten R¹ und R² mit der Bedeutung Alkyl oder Alkoxy kann entsprechend der durch H. Adkins und E.W. Reeve (J. Am. Chem. Soc. 1938, 60, 1328-1331) beschriebenen Beispiele erfolgen. Eine Nitrosierung der 1,3-Diketone mit den R¹ und R² mit der Bedeutung Amino kann nach M.A. Whiteley (J. Chem. Soc. Trans. 1900, 77, 1040-1046) erfolgen oder wie durch M. Conrad und A. Schulze in Ber. Deut. Chem. Gesell. 1909, 42, 729-735 beschrieben. Eine Nitrierung der 1,3-Diketone mit den R¹ und R² mit der Bedeutung Alkoxy kann nach Methoden erfolgen, wie sie in den folgenden Literaturstelle D.I. Weisblat, D.A. Lyttle, United States Patent No. 2,644,838 beschrieben sind. Die Nitrierung der 1,3-Diketone mit den Resten R¹ und R² mit der Bedeutung Alkyl, Alkoxy kann auch nach A.L. Laikhter, V.P. Kisiyi, V.V. Semenov, (Mendeleev Commun. 1993, 3, 20-21) oder nach S. Sifniades (J. Org. Chem. 1975, 40, 3562-3566) erfolgen. Zur Nitrierung der 1,3-Diketone mit den Resten R¹ und R² mit der Bedeutung Amino kann wiederum nach M. Sebban, J. Guillard, P. Palmas und D. Poullain (Magn. Reson. Chem. 2005, 43, 563-566) vorgegangen werden. Eine Sulfonierung der 1,3-Diketone mit den Resten R¹ und R² mit der Bedeutung Alkyl oder Alkoxy kann nach H. Böhme und R. Marx (Ber. Deut. Chem. Gesell. 1941, 74, 1664-1667) erfolgen.

Auch die in den Beispielen beschriebenen Liganden, die zur Herstellung von erfindungsgemäßen Metalloxidschichten beispielhaft verwendet worden sind, lassen sich nach diesen literaturbekannten Methoden herstellen.

Derivatisierte 1,3-Diketone der Formel (I) lassen sich, wie oben beschrieben, in einfacher Weise mit den oben genannten Metallverbindungen zu den gewünschten Metallkomplexen umsetzen, die als Vorprodukte zur Herstellung dünner Metalloxidschichten eingesetzt werden können. Abhängig von den Resten R¹, R² und den Substituenten X bzw. HX lassen sich die Metallkomplexe durch Erhitzen auf Temperaturen bis zu 600 °C, beispielsweise durch Bestrahlen durch UV, IR oder Laser, in die Metalloxide umwandeln, wobei die freigesetzten organischen Zersetzungsprodukte verdampfen. Bevorzugt sind in diesem Zusammenhang solche Metallkomplexe, die möglichst in wässrigen Systemen löslich sind und sich beim Erhitzen bei niedrigeren Temperaturen, insbesondere bei Temperaturen im Bereich von 150 bis 350 °C, zu den entsprechenden Metalloxiden umwandeln. Versuche haben gezeigt, dass Metallkomplexe der Liganden 2-Nitrodimethylmalonat bzw. 2-Hydroxyiminodimethylmalonat sowohl hinsichtlich der Löslichkeit als auch der Umwandlungstemperatur besonders geeignet sind.

Zur Herstellung der Metalloxidschichten werden die erfindungsgemäßen Metallkomplexe als Vor- oder Zwischenprodukte zunächst in einem Lösemittel mit geeigneter Flüchtigkeit und Viskosität wie z.B. in Methoxyethanol, Dimethylformamid oder Dimethoxyethan, gegebenenfalls in Gegenwart von Wasser, gelöst. Das Aufbringen auf die Substratoberfläche kann durch Nassbeschichtung nach bekannten Verfahren, wie Spincoating, Dipcoating, Spraycoating, Inkjet-Druck, Flexodruck oder Gravurdruck erfolgen. Geeignete Beschichtungsverfahren aus Lösungen sind durch R. M. Pasquarelli et al. in Chem. Soc. Rev., 2011, 40, 5406-5441 beschrieben. Die Umwandlung der aufgebrachten Metallkomplexe in die gewünschte oxidische Beschichtung erfolgt nach dem Trocknen in einem weiteren Schritt mittels Erhitzen in einem Ofen oder auf einer Heizplatte oder mittels Bestrahlen durch UV, IR oder Laser, wobei sich erfindungsgemäß das oxidische Material in Form einer dünnen Schicht ausbildet. Um in besonderen Fällen ausreichend dicke Schichten zu erzeugen, können die Schritte, Lösung aufbringen, Trocknen und Erhitzen mehrfach wiederholt werden. Hier ist es auch möglich, die verschiedenen Auftragsschritte mit Lösungen verschiedener Metallkomplexe durchzuführen, so dass sich Schichten mit unterschiedlichen Metalloxiden ausbilden. Es ist aber auch möglich, in der aufzubringenden Lösung zwei oder mehrere verschiedene Metallkomplexe zu lösen, so dass man nach der Umwandlung durch Erhitzen, bzw. Kalzinieren gemischte Oxide verschiedener Metalle erhalten werden.

Die vorliegende Beschreibung ermöglicht es dem Fachmann, die Erfindung umfassend anzuwenden und auszuführen. Auch ohne weitere Ausführungen wird daher davon ausgegangen, dass ein Fachmann die obige Beschreibung im weitesten Umfang nutzen kann.

Bei etwaigen Unklarheiten versteht es sich von selbst, die zitierten Veröffentlichungen und die Patentliteratur heranzuziehen. Dementsprechend gelten diese Dokumente als Teil der Offenbarung der vorliegenden Beschreibung.

Zum besseren Verständnis und zur Verdeutlichung der Erfindung werden im Folgenden Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Weiterhin versteht es sich für den Fachmann von selbst, dass sich sowohl in den gegebenen Beispielen als auch in der übrigen Beschreibung die in den Zusammensetzungen enthaltenen Komponentenmengen in der Summe immer nur zu 100 Gew.- bzw. mol-% bezogen auf die Gesamtzusammensetzung aufaddieren und nicht darüber hinausgehen können, auch wenn sich aus den angegebenen Prozentbereichen höhere Werte ergeben könnten. Sofern nichts anderes angegeben ist, gelten %-Angaben als Gew.- oder mol-%, mit Ausnahme von Verhältnissen, die in Volumenangaben wiedergegeben sind und zu deren Herstellung beispielsweise Lösungsmittel in bestimmten Volumenverhältnissen im Gemisch verwendet werden.

Die in den Beispielen und der Beschreibung sowie in den Ansprüchen gegebenen Temperaturen gelten immer in °C.

### Beispiele

Die im Folgenden wiedergegebenen Ausführungsbeispiele entsprechen den sogenannten "Best Mode"-Beispielen, wie sie zum Zeitpunkt der Einreichung der Anmeldung vorliegen.

### Beispiel 1

### Synthese des Zinkkomplexes mit Nitrodimethylmalonat

10 g (56.8 mmol) 2-Nitro-1,3-dimethylmalonat werden in 200 ml dest. Wasser vorgegeben. Nach Zugabe von 10 g (91.1 mmol Zn) Hydrozinkit entsteht eine gelbe Suspension, die noch 3 Stunden lang gerührt wird. Danach wird der Überschuss an Hydrozinkit abfiltriert und die Lösung am Rotationsverdampfer bei 65 °C und 130 mbar vollständig eingeengt. Das verbliebene gelbe Öl wird in 50 ml Dichlormethan aufgenommen und filtriert. Das Produkt wird durch Eintropfen der Lösung in 200 ml Methyl-tert.-Butylether gefällt, abfiltriert und im Hochvakuum bei Raumtemperatur getrocknet. Man erhält ein schwach gelbliches Pulver (6.4 g, 34.2 %).

Keramische Ausbeute (CY)/Elementaranalyse (CHN): Gefunden CY 39.87 %, C 19.86 %, N 4.50 %, H 2.78 %. Berechnet für Zn₃(OH)₄(C₅H₆NO₆)₂ CY 39.63%, C 19.49 %, N 4.54 %, H 2.62 %. ¹H-NMR (DMSO-d₆): 3.57 (-CH₃), 3.40 (OH). ¹³C-NMR/¹³C-DEPT-NMR (DMSO-d₆): 50.91 (-CH₃); 109.07 (-C-NO₂); 163.72 (-COO). IR: 3460 cm⁻¹, v br (v O-H).

### Beispiel 2

Synthese des Zinkkomplexes mit Hydroxyiminodimethylmalonat Unter Schutzgas werden Lösungen von Zink-2-propanolat (1.33 g, 7.2 mmol) bzw. 2-Hydroxyiminodimethylmalonat (3.50 g, 21.7 mmol) in jeweils 10 ml Tetrahydrofuran hergestellt. Anschließend wird die Lösung der Zinkverbindung auf 0 °C gekühlt und der Ligand zugetropft. Die Lösung färbt sich sofort gelb und beim Erwärmen auf Raumtemperatur bildet sich ein Niederschlag. Das Produkt wird abfiltriert, zweimal mit je 10 ml Methyl-tert.-Butylether gewaschen und im Hochvakuum bei Raumtemperatur für mehrere Stunden getrocknet. Man erhält 1.84 g (82.3 %) eines gelblichen Pulvers. Das Produkt ist unter Umgebungsbedingungen stabil.

Keramische Ausbeute (CY)/Elementaranalyse (CHN): Gefunden CY 26.50 %, C 29.52 %, N 6.60 %, H 2.98 %. Berechnet für Zn₄O(C₅H₈NO₅)₂ CY 26.29%, C 29.10 %, N 6.79 %, H 2.92 %. ¹H-NMR (DMSO-d₆): 3.69, 3.72 (-CH₃). ¹³C-NMR/¹³C-DEPT-NMR (DMSO-d₆): 51.62 (-CH₃); 143.36 (-C=NO); 162.70, 164.69 (-COO).

### Beispiel 3

### Synthese des Zinkkomplexes mit Nitromalonsäurediamid

Zu Nitromalonsäureamid (2.19 g, 15.00 mmol) werden 15 ml einer 1.0 M wässerigen Lösung von Tetramethylammoniumhydroxid gegeben. Die entstehende gelbe Lösung wird 30 Minuten lang gerührt. Anschließend wird festes Zinknitrat-Hexahydrat (2.23 g, 7.50 mmol) zugegeben. Es fällt ein weißer Feststoff aus, der abfiltriert und zweimal mit je 10 ml kaltem Wasser gewaschen wird. Nach dem Trocknen erhält man 2,38 g (80.67 %).

Keramische Ausbeute (CY)/Elementaranalyse (CHN): Gefunden CY 21.53 %, C 18.75 %, N 21.18 %, H 3.15 %. Berechnet für Zn(C₃H₄N₃O₄)₂(H₂O)₂ CY 20.68 %, C 18.31 %, N 21.35 %, H 3.07 %. ¹H-NMR (DMSO-d₆): 9.23, 7.78 (br, -NH₂), 3.39 (br, H₂O). 13C-NMR/¹³C-DEPT-NMR (DMSO-d₆): 112.46 (-C-NO₂); 168.36 (-CONH₂).

### Beispiel 4

### Synthese des Zinn(II)komplexes mit Nitrodimethylmalonat

Unter Schutzgas wird zu 1.0 g (5.53 mmol) Zinn(II)-methoxid eine Lösung aus 1.96 g (11.07 mmol) 2-Nitrodimethylmalonat in 10 ml Methyl-tert.-Butylether gegeben. Die Suspension wird anschließend für eine Stunde gerührt, der Feststoff abfiltriert und zweimal mit 10 ml Methyl-tert.-Butylether gewaschen. Nach dem Trocknen im Hochvakuum wird das Produkt in Form eines gelben Pulvers (2.06 g) erhalten. Das Produkt ist unter Umgebungsbedingungen stabil.

Keramische Ausbeute (CY)/Elementaranalyse (CHN): Gefunden CY 64.25 %, C 13.85 %, N 2.93 %, H 2.12 %. Berechnet für Sn₄(OH)₆(C₅H₆NO₆)₂ CY 64.58 %, C 12.93 %, N 3.02 %, H 1.95 %. ¹H-NMR (DMSO-d₆): 3.83 (-CH₃), 3.50 (OH). ¹³C-NMR/¹³C-DEPT-NMR (DMSO-d₆): 52.09 (-CH₃); 143.24 (-C-NO₂); 160.33 (-COO). IR: 3446 cm⁻¹, v br (v O-H).

### Beispiel 5

### Synthese des Indiumkomplexes mit Nitrodimethylmalonat

Unter Schutzgas werden 1.5 g (4.49 mmol) Indiumbutoxid in 10 ml Toluol gelöst und eine Lösung aus 2.39 g (13.49 mmol) 2-Nitrodimethylmalonat in 10 ml Toluol hinzugegeben. Dabei fällt sofort ein gelblich-weißer Feststoff aus. Das Produkt wird abfiltriert, mit zweimal je 10 ml Toluol gewaschen und im Hochvakuum getrocknet. Man erhält ein gelblich weißes Pulver (1.93 g), das unter Umgebungsbedingungen stabil ist.

Keramische Ausbeute (CY)/Elementaranalyse (CHN): Gefunden CY 41.83 %, C 26.77 %, N 4.18 %, H 3.22 %. Berechnet für In₃O₃(C₅H₆NO₆)₃(C₇H₈) CY 41.11 %, C 26.09 %, N 4.15 %, H 2.59 %. ¹H-NMR (DMSO-d₆): 3.73 (-CH₃). ¹³C-NMR/¹³C-DEPT-NMR (DMSO-d₆): 50.03 (-CH₃); 108.14 (-C-NO₂); 162.67 (-COO).

### Beispiel 6

### Synthese des Zirkoniumkomplexes mit Hydroxyiminodimethylmalonat

Unter Schutzgas werden 1,0 g (3,1 mmol) Zirkonium-1-propanolat (70 Gewichts% in 1-Propanol) in 2 ml Tetrahydrofuran gelöst. Dazu wird die Lösung von 2,0 g (12,4 mmol) 2-Hydroxyiminodimethylmalonat in 4 ml Tetrahydrofuran dazugegeben. Die Reaktionsmischung wird 30 Minuten weiter gerührt. Das Lösemittel wird unter Vakuum vollständig abdestilliert und das verbleibende Öl in 3 ml Methyl-tert.-butylether/Chloroform (v:v; 1:1) aufgenommen. Das Produkt wird durch Eintropfen in 60 ml Pentan gefällt, abfiltriert und im Hochvakuum getrocknet. Man erhält ein gelblich weißes Pulver (Ausbeute: 1,21g, 56,3 %), das unter Umgebungsbedingungen stabil ist.

Keramische Ausbeute (CY)/Elementaranalyse (CHN): Gefunden CY 29.21 %, C 29.17 %, N 6.32 %, H 3.48 %. Berechnet für Zr₆O₄(OH)₄(C₅H₈N)₁₂ CY 28.43%, C 27.71 %, N 6.46 %, H 2.95 %.
¹H-NMR (DMSO-d₆): 3.78, 3.84 (-CH₃), 3.57 (OH). ¹³C-NMR/¹³C-DEPT-NMR (DMSO-d₆): 50.53 (-CH₃); 142.18 (-C-NO₂); 163.10, 160.56 (-COO). IR: 3430 cm⁻¹, v br (v O-H).

### Beispiel 7

### Synthese des Zirkoniumkomplexes mit Nitrodimethylmalonat

Unter Schutzgas wird 1,0 g (3,1 mmol) Zirkonium-1-propanolat (70 Gewichts% in 1-Propanol) in 2 ml Toluol gelöst. Dazu wird eine Lösung von 2,0 g (12,4 mmol) 2-Nitrodimethylmalonat in 4 ml Toluol gegeben. Die Reaktionsmischung wird 30 Minuten weiter gerührt. Das Lösemittel wird vollständig abkondensiert und das verbleibende Öl in 3 ml Methyl-tert.-Butylether/Chloroform (v:v; 1:1) aufgenommen. Das Produkt wird durch Eintropfen in 60 ml Pentan gefällt, abfiltriert und im Hochvakuum getrocknet. Man erhält ein gelblich weißes Pulver (Ausbeute: 1,21g, 56,3 %), das unter Umgebungsbedingungen stabil ist.

Keramische Ausbeute (CY)/Elementaranalyse (CHN): Gefunden CY 27.17 %, C 27.52 %, N 5.83 %, H 2.84 %. Berechnet für Zr₆O₄(OH)₄(C₅HₐNO₆)₁₂ CY 26.47%, C 25.81 %, N 6.02 %, H 2.74 %. ¹H-NMR (DMSO-d₆): 3.80 (-CH₃), 3.67 (OH). ¹³C-NMR/¹³C-DEPT-NMR (DMSO-d₆):48.54 (-CH₃); 108.43 (-C-NO₂); 163.10 (-COO). IR: 3436 cm⁻¹, v br (v O-H).

Die gemäß der Beispiele 1 - 6 hergestellten Metallkomplexe können nun wie oben beschrieben in einem geeigneten Lösungsmittel aufgenommen werden und durch Nassbeschichtung, wie durch R. M. Pasquarelli et al. in Chem. Soc. Rev., 2011, 40, 5406-5441 beschrieben, auf das Substrat aufgebracht werden und nach dem Trocknen in die gewünschte keramische Beschichtung umgewandelt werden.

### Beispiel 8

### Herstellung von Dünnschichttransistoren

Substrate für Feldeffekttransistoren bestehen aus hoch n-dotiertem Silicium mit einer Dielektrikumsschicht aus Siliciumdioxid (90 nm), auf der Goldelektroden (40 nm) mit einer Zwischenschicht aus Indium-Zinn-Oxid (5 nm) aufgebracht sind. Die Elektroden sind in Form einer Interdigitalstruktur angeordnet mit einer Kanalweite W von 10 mm und einer Kanallänge L von 10 µm (Detaillierte Beschreibung und Abbildungen in J. J. Schneider et al., Adv. Mater. 2008, 20, 3383-3387).
Die Ladungsträgerbeweglichkeit µ_{SAT} und die Schwellspannung Vₜₕ werden durch lineare Anpassung der Quadratwurzel des Source-Drain-Stroms (I_{DS}^{0.5}) als Funktion der Gate-Source-Spannung V_{GS} bestimmt.

Zur Beschichtung mit Indium-Zink-Oxid werden zwei Lösungen mit einem Gehalt von 1 Gew.-% der oben beschriebenen Indium- und Zinkkomplexe mit Nitrodimethylmalonat in Methoxyethanol hergestellt. Davon werden anschließend 1 g (In) und 0.24 g (Zn) gemischt, so dass die IZO-Precusorlösung ein molares Verhältnis In: Zn von 70:30 aufweist. Die IZO-Precursor-Lösung wird durch Spincoating (1000 rpm für 10 s gefolgt von 2000 rpm für 20 s) auf die zuvor beschriebenen Substrate aufgebracht und bei 350 °C auf einer Heizplatte für 4 Minuten kalziniert. Anschließend wird die Beschichtung zum Aufbringen einer zweiten Schicht wiederholt.

Zur Beschichtung mit Zinkoxid wird eine Lösung mit einem Gehalt von 1 Gew.-% des oben beschriebenen Zinkkomplexes mit Nitromalonsäureamid in Methoxyethanol hergestellt. Die Precursor-Lösung wird durch Spincoating (1000 rpm für 10 s gefolgt von 2000 rpm für 20 s) auf die zuvor beschriebenen Substrate aufgebracht und bei 350 °C auf einer Heizplatte für 4 Minuten kalziniert. Anschließend wird die Beschichtung zur Aufbringung von zwei weiteren Schichten wiederholt.

### Beispiel 9

### Herstellung eines Kondensators

Substrate zur Herstellung von Kondensatoren bestehen üblicherweise aus Glas (1,5 x 1,5 cm²) auf das durch Sputterbeschichturig und einem Ätzprozess rechteckige Flächen von Indium-Zinnoxid aufgebracht werden. (Die Flächen sind unterschiedlich groß. Auf einem Substrat befinden sich jeweils zwei Flächen zu 2 mm x 0,99 mm sowie 2 mm x 0,975 mm und 2 mm x 0,95 mm. Zur besseren Kontaktierung wird weiter über eine Maske Gold (40 nm) mit einer Fläche von 0,8 mm x 1 mm überlappend auf einem Teil der ITO-Flächen mittels Sputtercoating abgeschieden. Zur Beschichtung mit Zirkoniumdioxid wird eine Lösung mit einem Gehalt von 10 Masse% des oben beschriebenen Zirkoniumkomplexes mit Nitrodimethylmalonat in Methoxyethanol hergestellt. Diese wird mittels Spincoating (1500 rpm für 30 s) auf das Substrat aufgebracht und bei 350 °C für 20s auf einer Heizplatte kalziniert. Der Prozess wird wiederholt, so dass insgesamt drei Schichten aufgebracht werden. Danach wird das Substrat abschließend mit allen drei Schichten für weitere 5 Minuten bei 350°C auf der Heizplatte prozessiert. Anschließend werden über eine Maske Goldelektroden (40 nm) (drei unterschiedliche Flächen von 230 x 990 µm, sowie 230 x 975 µm und 230 x 950 µm) quer über die Positionen der ITO-Flächen mittels Sputtercoating abgeschieden. Für die Messung erfolgt die Kontaktierung auf der Unter- bzw. der Oberseite der Schicht aus Zirkoniumdioxid über die zuvor erwähnten Goldkontakte auf dem ITO und den nachfolgend aufgebrachten Goldelektroden. Damit kann der Wechselstromwiderstand als komplexwertige Funktion der Frequenz gemessen werden, aus dem sich die Kapazität des Kondensators und daraus die Permittivität des Isolators bei bekannter Schichtdicke bestimmen lassen.

Durch Vermessung der elektrischen Parameter wurde gefunden, dass die erfindungsgemäß hergestellten Metalloxidschichten sich vorteilhaft in ihren physikalischen Eigenschaften von bekannten Produkten unterscheiden. Zur Veranschaulichung sind im Folgenden die gemessenen Daten graphisch dargestellt. Die im Anhang wiedergegebenen graphischen Darstellungen zeigen folgendes:

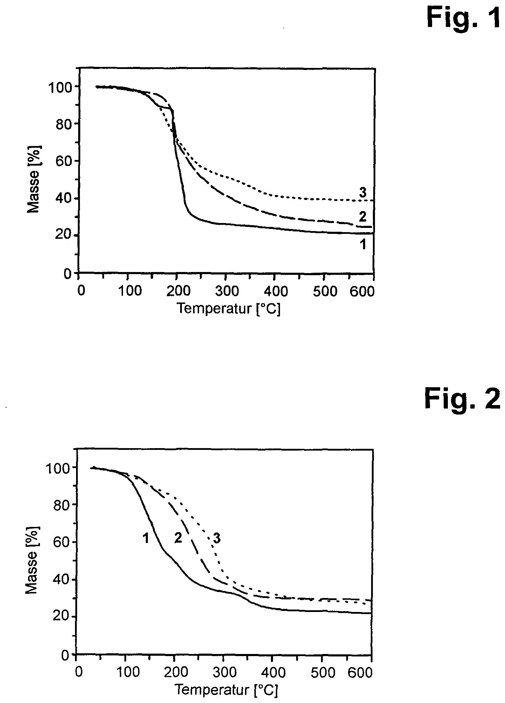

- Fig. 1:: Thermischer Zerfall der Zinkkomplexe mit Nitromalonsäureamid (1), Hydroxyiminodimethylmalonat (2) und Nitrodimethylmalonat (3). Dargestellt ist der Zerfall [%-Masse] in Abhängigkeit von der Temperatur [°C].
- Fig. 2:: Thermischer Zerfall der Zirkoniumkomplexe mit Nitrodimethylmalonat (1), Methylsulfonyldimethylmalonat (2) und Hydroxyiminodimethylmalonat (3). Dargestellt ist der Zerfall [%-Masse] in Abhängigkeit von der Temperatur [°C].

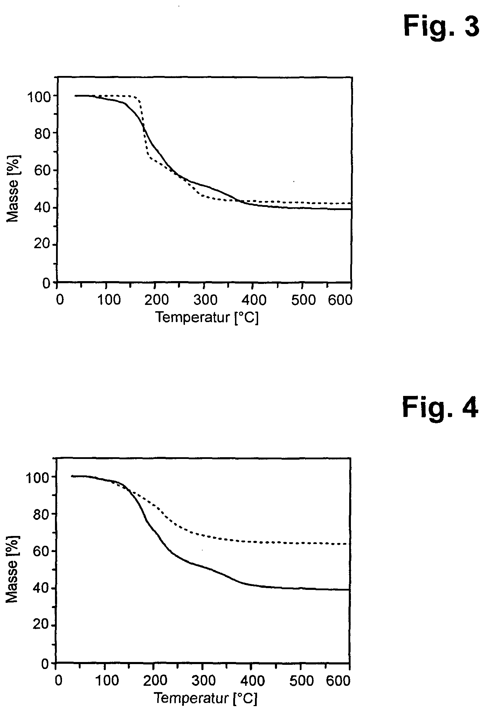

- Fig. 3:: Thermischer Zerfall der Zink- (durchgehende Kurve) und Indiumkomplexe (gestrichelte Kurve) mit Nitrodimethylmalonat. Dargestellt ist der Zerfall [%-Masse] in Abhängigkeit von der Temperatur [°C].
- Fig. 4:: Thermischer Zerfall der Zink- (durchgehende Kurve) und Zinn(II)komplexe (gestrichelte Kurve) mit Nitrodimethylmalonat. Dargestellt ist der Zerfall [%-Masse] in Abhängigkeit von der Temperatur [°C].

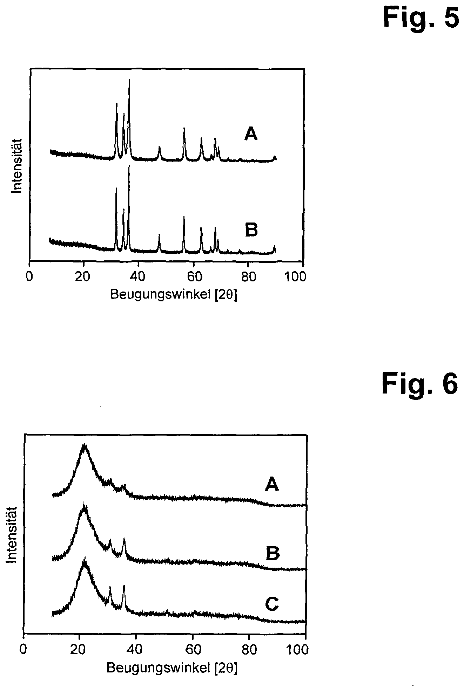

- Fig. 5:: Röntgendiffraktogramm von Pulvern aus dem Zinkkomplex von Nitrodimethylmalonat nach Kalzinieren bei Temperaturen von (A) 450 °C und (B) 600 °C. Die beobachteten Reflexe zeigen die Bildungen von kristallinem Zinkit.
Dargestellt ist die Intensität gegen den Beugungswinkel [2θ].
- Fig. 6:: Röntgendiffraktogramm von Pulvern aus dem Indiumkomplex von Nitrodimethylmalonat nach Kalzinieren bei Temperaturen von (A) 250 °C, (B) 350 °C. Die beobachteten Reflexe zeigen die Bildung von nanokristallinem Bixbyit.
Dargestellt ist die Intensität gegen den Beugungswinkel [2θ].

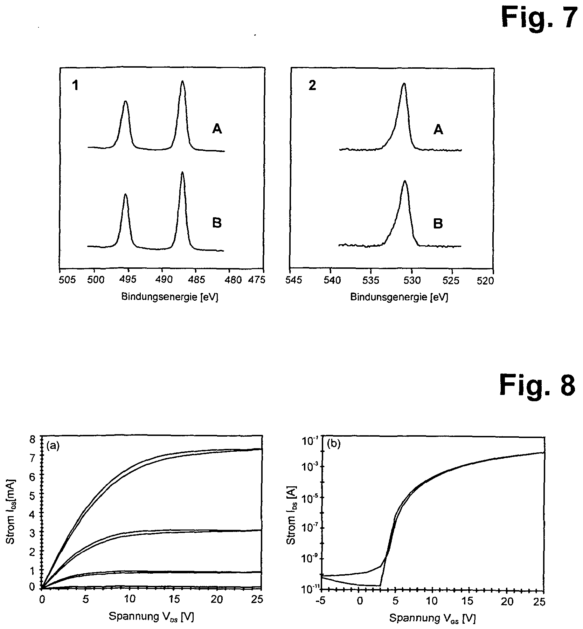

- Fig. 7:: Röntgenphotoelektronenspektren im Bereich der (1) Sn 3d- und (2) O 1s-Signale von keramischen Filmen aus dem Zinn(II)komplex von Nitrodimethylmalonat nach Kalzinieren bei (A) 270 °C und (B) 460 °C. Die Spektren zeigen, dass ausschließlich Zinn(IV)oxid gebildet worden ist. Es liegt bei elementares Zinn oder Zinn(II)oxid vor.
Dargestellt ist die Bindungsenergie [eV].
- Fig. 8:: Transistorkennlinien eines Films aus Indium-Zink-Oxid nach Kalzinieren bei 350 °C an Luft. (a) Output-Charakteristik für steigende und abnehmende Drain-Source-Spannungen bei konstanten Gate-Source-Spannungen von 0-25 V in 5 V-Schritten. (b) Transfer-Charakteristik bei konstanter Drain-Source-Spannung von 25 V. Aus der Kurvenanpassung wurden für die Kenngrößen erhalten: µ 2.8 cm²/(Vs), Vₜₕ 9.8 V und I_{on/off} ∼ 2*10⁸.
Dargestellt ist der gemessene Strom I_{DS} [mA] gegen die Spannung V_{DS} [V] bzw. Spannung V_{GS} [V].

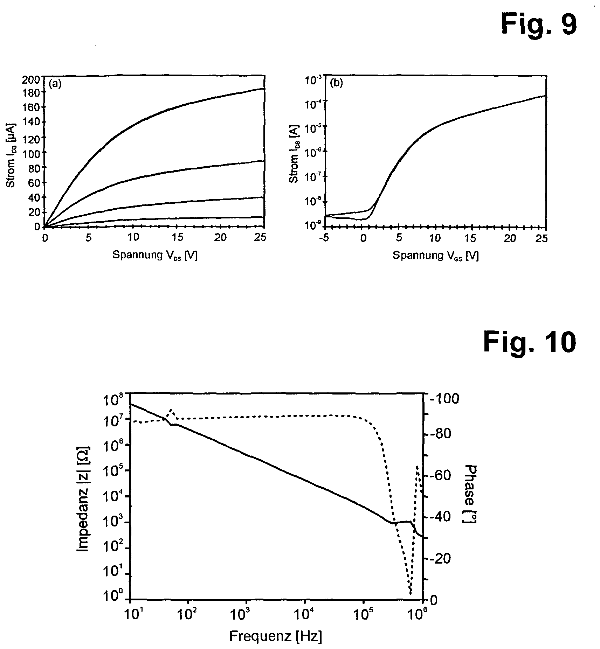

- Fig. 9:: Transistorkennlinien eines Films aus Zinkoxid nach Kalzinieren bei 350 °C an Luft. (a) Output-Charakteristik für steigende und abnehmende Drain-Source-Spannungen bei konstanten Gate-Source-Spannungen von 0-25 V in 5 V-Schritten. (b) Transfer-Charakteristik bei konstanter Drain-Source-Spannung von 25 V. Aus der Kurvenanpassung wurden für die Kenngrößen erhalten: µ 0.03 cm²/(Vs); Vₜₕ +6.3 V und I_{on/off} ∼3*10⁵. Dargestellt ist der gemessene Strom I_{DS} [mA] gegen die Spannung V_{DS} [V] bzw. Spannung V_{GS} [V].
- Fig. 10:: Impedanz und Phase als Funktion der Wechselstromfrequenz gemessen an einer Isolatorschicht aus Zirkoniumdioxid. Dargestellt ist die ermittelte Impedanz |z| [Ω] gegen die Frequenz [Hz].

## Patentansprüche

1. Metallkomplex mit in 2-Position funktionalisierten 1,3-Diketonen der allgemeinen Formel (I)
Mₗ[R¹-CO-C(H)ₘX-CO-R²]ₙ, (I)
worin
M Metallatom, ausgewählt aus der Gruppe Zink, Indium, Gallium, Zinn, Aluminium, Zirkonium, Titan und Hafnium,
l 1 oder 2,
m 0 oder 1,
n 1, 2, 3 oder 4,
R¹ und R² unabhängig voneinander Alkyl mit 1 bis 8 C-Atomen, Cycloalkyl mit 3 bis 7 C-Atomen, Alkoxy mit 1 bis 8 C-Atomen und/oder Amino, NHR³, NR³R⁴ mit R³, R⁴ unabhängig voneinander Alkyl mit 1 bis 8 C-Atomen, Cycloalkyl mit 3 bis 7 C-Atomen,
und
X Hydroxyimino-, Nitro, Sulfo, einschließlich -SO₂-alky mit 1 bis 8 C-Atomen, Phosphato, einschließlich -PO(O-R)₂ mit R = Alkyl mit 1 bis 8 C-Atomen, Alkoxy mit 1 bis 8 C-Atomen; Stannyl -SnR₃ mit R = Alkyl mit 1 bis 8 C-Atomen; Mercapto -SR mit R = H, Alkyl mit 1 bis 8 C-Atomen, Cycloalkyl mit 3 bis 7 C-Atomen, Halogenid, wie F, Cl, Br, I oder Pseudohalogenid, wie -CN, -N₃, -OCN, -NCO, -CNO, -SCN, -SeCN
bedeuten, mit der Maßgabe dass es sich bei dem Metallkomplex nicht um Tetrakis-(cyanodiethylmalonat)-zirkonium handelt.

2. Metallkomplex gemäß Anspruch 1, **dadurch gekennzeichnet, dass** R¹ und R² unabhängig voneinander Methyl, Ethyl, Propyl, Butyl, Pentyl, Cyclopropyl, Cyclobutyl, Cyclopentyl, Cyclohexyl, Methoxy, Ethoxy, Propoxy oder Amino bedeuten.

3. Metallkomplex gemäß Anspruch 1 oder 2, **dadurch gekennzeichnet, dass** X Hydroxyimino, Nitro, Sulfo, einschließlich -SO₂-alky mit 1 bis 8 C-Atomen, Halogenid, wie F, Cl, Br, I oder Pseudohalogenid, wie -CN, - N₃, -OCN, -NCO, -CNO, -SCN, -SeCN bedeutet.

4. Metallkomplex gemäß Anspruch 1, **dadurch gekennzeichnet, dass** es eine Verbindung ausgewählt aus der Gruppe Nitrodimethylmalonat, Hydroxyiminodimethylmalonat und Nitromalonsäurediamid, ist.

5. Metallkomplex-Cluster, gebildet aus mindestens zwei Metallkomplexmolekülen der allgemeinen Formel (I) gemäß einem oder mehreren der Ansprüche 1 bis 4, worin I eine Zahl ≥ 2 und n > 2 ist.

6. Verfahren zur Herstellung von dünnen Metalloxidschichten, **dadurch gekennzeichnet, dass**
ein oder mehrere Metallkomplex(e) gemäß einem oder mehreren der Ansprüche 1 bis 4 oder Metallkomplex-Cluster gemäß Anspruch 5 in einem geeigneten Lösungsmittel oder Lösungsmittelgemisch gelöst oder dispergiert wird,
die erhaltene Lösung oder Dispersion, der gegebenenfalls weitere Additive, ausgewählt aus der Gruppe Verflüssiger, Stabilisatoren, Binder und Entschäumer, zugesetzt sind, mittels Nassbeschichtung auf eine zu beschichtende Substratoberfläche aufgebracht, getrocknet und die aufgebrachte Schicht in einem weiteren Schritt mittels Erhitzen in einem Ofen, auf einer Heizplatte oder mittels Bestrahlen durch UV, IR oder Laser in ein Metalloxid in Form einer dünnen Schicht umgewandelt wird.

7. Verfahren gemäß Anspruch 6, **dadurch gekennzeichnet, dass** die das Metallkomplex enthaltende Lösung oder Dispersion ein Lösungsmittel ausgewählt aus der Gruppe Methoxyethanol, Dimethylformamid und Dimethoxyethan rein oder im Gemisch, gegebenenfalls in Gegenwart von Wasser, enthält.

8. Verfahren gemäß Anspruch 6 oder 7, **dadurch gekennzeichnet, dass** die Metallkomplex enthaltende Lösung oder Dispersion mittels Spincoating, Dipcoating, Spraycoating, Inkjet-Druck, Flexodruck oder Gravurdruck auf die Substratoberfläche aufgebracht wird.

9. Verfahren gemäß Anspruch 6, 7 oder 8, **dadurch gekennzeichnet, dass** die Umwandlung der aufgebrachten, getrockneten Metallkomplexschicht durch Erhitzen und Kalzinieren bei Temperaturen im Bereich von 150 - 350 °C durchgeführt wird.

10. Verfahren gemäß einem oder mehreren der Ansprüche 6 bis 9,
**dadurch gekennzeichnet, dass** dünne Oxidschichten der Metalle Zink, Indium, Gallium, Zinn, Aluminium, Zirkonium, Titan und Hafnium hergestellt werden, worin die Oxide rein oder im Gemisch, bzw. als Mischoxide vorliegen.

11. Verfahren gemäß einem oder mehreren der Ansprüche 6 bis 10,
**dadurch gekennzeichnet, dass** vor dem Erhitzen und Kalzinieren mehrfach Lösung oder Dispersion auf die Substratoberfläche aufgebracht wird, wobei jede Schicht einzeln getrocknet und getempert wird.

12. Verwendung der Metallkomplexe gemäß der Ansprüche 1 bis 4 oder Metallkomplex-Cluster gemäß Anspruch 5 zur Herstellung von dünnen keramischen Metalloxidschichten in elektronischen Bauteilen, wie Kondensatoren oder Dünnschichttransistoren.

13. Verwendung der Metallkomplexe gemäß der Ansprüche 1 bis 4 oder Metallkomplex-Cluster gemäß Anspruch 5, zur Herstellung von dünnen Metalloxidschichten in der Photovoltaik und der Halbleitertechnologie.

14. Verwendung der Metallkomplexe gemäß der Ansprüche 1 bis 4 oder Metallkomplex-Cluster gemäß Anspruch 5, zur Herstellung von dünnen Metalloxidschichten als Antikratz- oder Antireflexschichten.

15. Verwendung der Metallkomplexe gemäß der Ansprüche 1 bis 4 oder Metallkomplex-Cluster gemäß Anspruch 5, zur Herstellung von dünnen Metalloxidschichten in Solarzellen, Flachbildschirmen und Touchscreens, oder als Kontakte, Leiter, Halbleiter und Dielektrika in Feldeffekttransistoren.

## Claims

1. Metal complex with 1,3-diketones of the general formula (I) which are functionalised in the 2 position,
Mₗ[R¹-CO-C(H)ₘX-CO-R²]ₙ, (I)
in which
M denotes a metal atom selected from the group zinc, indium, gallium, tin, aluminium, zirconium, titanium and hafnium,
l denotes 1 or 2,
m denotes 0 or 1,
n denotes 1, 2, 3 or 4,
R¹ and R², independently of one another, denote alkyl having 1 to 8 C atoms, cycloalkyl having 3 to 7 C atoms, alkoxy having 1 to 8 C atoms and/or amino, NHR³ or NR³R⁴, where R³ and R⁴, independently of one another, denote alkyl having 1 to 8 C atoms or cycloalkyl having 3 to 7 C atoms,
and
X denotes hydroxyimino, nitro, sulfo, including -SO₂-alkyl having 1 to 8 C atoms, phosphato, including -PO(O-R)₂, where R = alkyl having 1 to 8 C atoms or alkoxy having 1 to 8 C atoms; stannyl -SnR₃, where R = alkyl having 1 to 8 C atoms; mercapto -SR, where R = H, alkyl having 1 to 8 C atoms or cycloalkyl having 3 to 7 C atoms, halide, such as F, Cl, Br or I, or pseudohalide, such as -CN, -N₃, -OCN, -NCO, -CNO, -SCN or -SeCN,
with the proviso that the metal complex is not tetrakis(cyanodiethyl-malonate)zirconium.

2. Metal complex according to Claim 1, **characterised in that** R¹ and R², independently of one another, denote methyl, ethyl, propyl, butyl, pentyl, cyclopropyl, cyclobutyl, cyclopentyl, cyclohexyl, methoxy, ethoxy, propoxy or amino.

3. Metal complex according to Claim 1 or 2, **characterised in that** X denotes hydroxyimino, nitro, sulfo, including -SO₂-alkyl having 1 to 8 C atoms, halide, such as F, Cl, Br or I, or pseudohalide, such as -CN, -N₃, -OCN, -NCO, -CNO, -SCN or -SeCN.

4. Metal complex according to Claim 1, **characterised in that** it is a compound selected from the group nitrodimethyl malonate, hydroxyimino-dimethyl malonate and nitromalonic acid diamide.

5. Metal complex cluster, formed from at least two metal-complex molecules of the general formula (I) according to one or more of Claims 1 to 4 in which I is a number ≥ 2 and n is > 2.

6. Process for the production of thin metal-oxide layers, **characterised in that**
one or more metal complex(es) according to one or more of Claims 1 to 4 or metal complex cluster(s) according to Claim 5 is (are) dissolved or dispersed in a suitable solvent or solvent mixture,
the solution or dispersion obtained, to which further additives selected from the group liquefiers, stabilisers, binders and antifoams have optionally been added, is applied by means of wet coating to a substrate surface to be coated, dried, and the applied layer is converted into a metal oxide in the form of a thin layer in a further step by means of heating in an oven, on a hotplate or by means of irradiation by UV, IR or laser.

7. Process according to Claim 6, **characterised in that** the solution or dispersion comprising the metal complex comprises a solvent selected from the group methoxyethanol, dimethylformamide and dimethoxyethane, in pure form or in a mixture, optionally in the presence of water.

8. Process according to Claim 6 or 7, **characterised in that** the solution or dispersion comprising the metal complex is applied to the substrate surface by means of spin coating, dip coating, spray coating, ink-jet printing, flexographic printing or gravure printing.

9. Process according to Claim 6, 7 or 8, **characterised in that** the conversion of the applied, dried metal-complex layer is carried out by heating and calcination at temperatures in the range from 150 - 350°C.

10. Process according to one or more of Claims 6 to 9, **characterised in that** thin oxide layers of the metals zinc, indium, gallium, tin, aluminium, zirconium, titanium and hafnium are produced in which the oxides are present in pure form or in a mixture, or as mixed oxides.

11. Process according to one or more of Claims 6 to 10, **characterised in that** the solution or dispersion is applied a number of times to the substrate surface before the heating and calcination, with each layer being dried and heated individually.

12. Use of the metal complexes according to Claims 1 to 4 or metal complex clusters according to Claim 5 for the production of thin ceramic metal-oxide layers in electronic components, such as capacitors or thin-film transistors.

13. Use of the metal complexes according to Claims 1 to 4 or metal complex clusters according to Claim 5 for the production of thin metal-oxide layers in photovoltaics and semiconductor technology.

14. Use of the metal complexes according to Claims 1 to 4 or metal complex clusters according to Claim 5 for the production of thin metal-oxide layers as antiscratch or antireflection layers.

15. Use of the metal complexes according to Claims 1 to 4 or metal complex clusters according to Claim 5 for the production of thin metal-oxide layers in solar cells, flat-panel screens and touch screens, or as contacts, conductors, semiconductors and dielectrics in field-effect transistors.

## Revendications

1. Complexe métallique avec des 1,3-dicétones de la formule générale (I), lesquels sont fonctionnalisés à la position 2 :
Mₗ[R¹-CO-C(H)ₘX-CO-R²]ₙ, (I)
dans laquelle :
M représente un atome métallique qui est sélectionné parmi le groupe comprenant le zinc, l'indium, le gallium, l'étain, l'aluminium, le zirconium, le titane et le hafnium,
l représente 1 ou 2,
m représente 0 ou 1,
n représente 1,2,3 ou 4,
R¹ et R² représentent, indépendamment l'un de l'autre, alkyle qui comporte 1 à 8 atome(s) de C, cycloalkyle qui comporte 3 à 7 atomes de C, alcoxy qui comporte 1 à 8 atome(s) de C et/ou amino, NHR³ ou NR³R⁴, où R³ et R⁴ représentent, indépendamment l'un de l'autre, alkyle qui comporte 1 à 8 atome(s) de C ou cycloalkyle qui comporte 3 à 7 atomes de C,
et
X représente hydroxyimino, nitro, sulfo, incluant -SO₂-alkyle qui comporte 1 à 8 atome(s) de C, phosphato, incluant-PO(O-R)₂, où R = alkyle qui comporte 1 à 8 atome(s) de C ou alcoxy qui comporte 1 à 8 atome(s) de C ; stannyle -SnR₃, où R = alkyle qui comporte 1 à 8 atome(s) de C ; mercapto -SR, où R = H, alkyle qui comporte 1 à 8 atome(s) de C ou cycloalkyle qui comporte 3 à 7 atomes de C, halogénure, tel que F, Cl, Br ou I, ou pseudo-halogénure, tel que -CN, -N₃, -OCN, -NCO, -CNO, -SCN ou -SeCN,
étant entendu que le complexe métallique n'est pas tétrakis(cyano-diéthylmalonate)zirconium.

2. Complexe métallique selon la revendication 1, **caractérisé en ce que** R¹ et R² représentent, indépendamment l'un de l'autre, méthyle, éthyle, propyle, butyle, pentyle, cyclopropyle, cyclobutyle, cyclo-pentyle, cyclohexyle, méthoxy, éthoxy, propoxy ou amino.

3. Complexe métallique selon la revendication 1 ou 2, **caractérisé en ce que** X représente hydroxyimino, nitro, sulfo, incluant -SO₂-alkyle qui comporte 1 à 8 atome(s) de C, halogénure, tel que F, Cl, Br ou I, ou pseudo-halogénure, tel que -CN, -N₃, -OCN, -NCO, -CNO, -SCN ou -SeCN.

4. Complexe métallique selon la revendication 1, **caractérisé en ce qu'**il s'agit d'un composé qui est sélectionné parmi le groupe comprenant malonate de nitrodiméthyle, malonate d'hydroxyiminodiméthyle et diamide d'acide nitromalonique.

5. Groupement de complexe(s) métallique(s), formé à partir d'au moins deux molécules de complexe métallique de la formule générale (I) selon une ou plusieurs des revendications 1 à 4 dans lequel I est un nombre ≥ 2 et n est > 2.

6. Procédé pour la production de couches minces en oxyde métallique, **caractérisé en ce que** :
un ou plusieurs complexe(s) métallique(s) selon une ou plusieurs des revendications 1 à 4 ou groupement(s) de complexe(s) métallique(s) selon la revendication 5 est (sont) dissout(s) ou dispersé(s) dans un solvant ou mélange de solvants approprié,
la solution ou dispersion obtenue, à laquelle d'autres additifs qui sont sélectionnés parmi le groupe comprenant des fluidifiants, des stabilisateurs, des liants et des antimousses ont, en option, été ajoutés, est appliquée au moyen d'un revêtement par voie humide sur une surface de substrat destinée à être revêtue, est séchée, et la couche appliquée est convertie selon un oxyde métallique sous la forme d'une couche mince au niveau d'une autre étape au moyen d'un chauffage dans un four, sur une plaque chauffante ou au moyen d'une irradiation par UV, IR ou laser.

7. Procédé selon la revendication 6, **caractérisé en ce que** la solution ou dispersion qui comprend le complexe métallique comprend un solvant qui est sélectionné parmi le groupe qui comprend le méthoxyéthanol, le diméthylformamide et le diméthoxyéthane, selon une forme pure ou selon un mélange, en option en présence d'eau.

8. Procédé selon la revendication 6 ou 7, **caractérisé en ce que** la solution ou dispersion qui comprend le complexe métallique est appliquée sur la surface du substrat au moyen d'un revêtement/dépôt à la tournette/par centrifugation, d'un revêtement/dépôt par immersion/trempage, d'un revêtement/dépôt par pulvérisation, d'une impression par jet d'encre, d'une impression flexographique ou d'une impression par gravure.

9. Procédé selon la revendication 6, 7 ou 8, **caractérisé en ce que** la conversion de la couche de complexe métallique appliquée séchée est mise en oeuvre au moyen d'un chauffage et d'une calcination à des températures dans la plage de 150 - 350°C.

10. Procédé selon une ou plusieurs des revendications 6 à 9, **caractérisé en ce que** des couches minces en oxyde des métaux que sont le zinc, l'indium, le gallium, l'étain, l'aluminium, le zirconium, le titane et le hafnium sont produites, couches minces dans lesquelles les oxydes sont présents selon une forme pure ou selon un mélange, ou en tant qu'oxydes mélangés/mixtes.

11. Procédé selon une ou plusieurs des revendications 6 à 10, **caractérisé en ce que** la solution or dispersion est appliquée un certain nombre de fois sur la surface de substrat avant le chauffage et la calcination, chaque couche étant séchée et chauffée individuellement.

12. Utilisation des complexes métalliques selon les revendications 1 à 4 ou de groupements de complexe(s) métallique(s) selon la revendication 5 pour la production de couches minces en oxyde métallique céramique dans des composants électroniques, tels que des condensateurs ou des transistors à film mince.

13. Utilisation des complexes métalliques selon les revendications 1 à 4 ou des groupements de complexe(s) métallique(s) selon la revendication 5 pour la production de couches minces en oxyde métallique au niveau des technologies du photovoltaïque et des semiconducteurs.

14. Utilisation des complexes métalliques selon les revendications 1 à 4 ou des groupements de complexe(s) métallique(s) selon la revendication 5 pour la production de couches minces en oxyde métallique en tant que couches anti-rayures ou antireflets.

15. Utilisation des complexes métalliques selon les revendications 1 à 4 ou des groupements de complexe(s) métallique(s) selon la revendication 5 pour la production de couches minces en oxyde métallique dans des cellules solaires, des écrans plat et des écrans tactiles, ou en tant que contacts, conducteurs, semiconducteurs et diélectriques dans des transistors à effet de champ.
